Europäisches Patentamt

European Patent Office

Office européen des brevets

(19)

(11) Veröffentlichungsnummer: **0 176 744**
**B1**

(12) **EUROPÄISCHE PATENTSCHRIFT**

(45) Veröffentlichungstag der Patentschrift:
04.01.89

(51) Int. Cl.⁴: **H05K 7/20**

(21) Anmeldenummer: 85110584.1

(22) Anmeldetag: 22.08.85

(54) Vorrichtung zum Kühlen von elektronischen Baugruppen bzw. Bauelementen.

(30) Priorität: 31.08.84 DE 3432105

(43) Veröffentlichungstag der Anmeldung:
09.04.86 Patentblatt 86/15

(45) Bekanntmachung des Hinweises auf die Patenterteilung:
04.01.89 Patentblatt 89/1

(84) Benannte Vertragsstaaten:
AT BE CH DE FR GB IT LI NL SE

(56) Entgegenhaltungen:
EP-A- 0 020 084
EP-A- 0 026 443
EP-A- 0 051 024
DE-A- 2 755 811
DE-B- 1 103 433
US-A- 3 730 264
US-A- 3 874 444

(73) Patentinhaber: **Siemens Aktiengesellschaft Berlin und München, Wittelsbacherplatz 2, D-8000 München 2(DE)**

(72) Erfinder: **Heitzig, Claus-Peter, Dipl.-Ing. (FH), Kirchenstrasse 69, D-8034 Germering(DE)**

ACTORUM AG

**Beschreibung**

Die Erfindung bezieht sich auf eine Vorrichtung zum Kühlen von elektronischen Baugruppen bzw. Bauelementen, die in in einem Gestell übereinander angeordneten Einschüben untergebracht sind, mit Hilfe von den einzelnen Einschüben von deren jeweiliger Unterseite her zugeführter Kühlluft, die nach Erwärmung in dem jeweiligen Einschub aus diesem austritt.

Es ist bereits eine Vorrichtung bekannt (DE-PS 11 03 433) die zur Abführung und zur Umlenkung der durch Gehäuse und Geräteschränke für wärmeerzeugende Geräte, vorzugsweise elektrische Geräte, von unten hindurchgeleiteten Kühlluft mittels einer einen Teil oder deren ganz obere Abdeckung umfassenden angewinkelten Leitfläche mit seitlichen Wangen zur Verhinderung des seitlichen Kühlluftaustritts dient. Bei dieser bekannten Vorrichtung ist die für die austretende bzw. bei übereinandergestellten Gehäusen für die austretende und eintretende Kühlluft vorgesehene plattenartig ausgebildete Leitfläche mit ihren seitlichen Wangen um in der Nähe des oberen Gehäuserandes vorgesehene Drehzapfen schwenkbar in die Ebene des Gehäuserandes einklappbar. Durch diese Konstruktion ist es bei übereinandergestellten Gehäusen bzw. Einschüben lediglich möglich, eine Kühlluftströmung von der jeweiligen Vorderseite zur jeweiligen Rückseite durch das jeweilige Gehäuse bzw. durch den jeweiligen Einschub zu erzielen. Dies bedeutet, daß für die in unterschiedlichen Höhen angeordneten Gehäuse unterschiedlich warme Kühlluft zur Verfügung steht, womit die Kühlwirkung für die verschiedenen Gehäuse sehr unterschiedlich sein wird.

Es ist ferner auch schon eine als Wärmeaustauscher für elektronische Systeme bezeichnete Kühlvorrichtung bekannt (US-PS 3 730 264), bei der in einem Gestell für die Aufnahme von mehreren übereinander liegenden Einschüben zwischen jeweils zwei Einschubreihen ein V-förmiges Umleitblech vorgesehen ist, welches so geformt ist, daß es die aus dem unteren Einschub nach oben entweichende Wärme an einem Eintreten in die Eintrittszone des darüberliegenden Einschubs derart hindert, daß die aus sämtlichen Einschüben austretende Warmluft auf ein und derselben Gestellseite, beispielsweise der Gestellrückseite, austritt. Damit haftet aber auch dieser bekannten Vorrichtung der Nachteil an, daß die in unterschiedlichen Höhen befindlichen Einschübe unterschiedlich warme Kühlluft zugeführt erhalten und damit unterschiedlichen Kühlwirkungen ausgesetzt sind.

Es ist ferner eine Kühlvorrichtung bekannt (US-PS 3 874 444), bei der in einem Gestell übereinanderliegend mehrere Einschübe vorgesehen sind, wobei zwischen unmittelbar übereinander liegenden Einschüben jeweils Trennbleche so angeordnet sind, daß sie zum einen die aus dem jeweiligen unteren Einschub austretende Warmluft zur Gestellrückseite hin ableiten und zum anderen von der Gestellvorderseite her Kaltluft in den jeweils darüberliegenden Einschub einzuleiten gestatten. Damit haftet aber auch dieser bekannten Vorrichtung der Mangel an, der im Zusammenhang mit der eingangs betrachteten bekannten Vorrichtung aufgezeigt worden ist.

Es ist ferner ein mehretagiges gekapseltes Schaltfeld mit Ventilationseinrichtung bekannt (DE-AS 2 755 811), bei dem eine Raumteilung in mehrere Gefache erfolgt ist, die jeweils eine eigene Fronttür besitzen und Geräte enthalten. Die Fronttür ist dabei mit einem Lufteinlaß versehen, und die Seiten der erwähnten Gefache sind zu einem Pfad für die abströmende Luft ausgebildet. Von Nachteil bei diesem bekannten Schaltfeld ist jedoch ebenfalls der Umstand, daß für die in unterschiedlichen Höhen befindlichen Geräte infolge der unterschiedlich warmen Kühlluft die Kühlwirkung unterschiedlich ist.

Es ist nun auch schon eine Einrichtung zum Abführen der Verlustleistungswärme von in einem Schrankgestell eingebauten elektronischen Geräteeinschüben bekannt (DE-AS 2 939 088), wobei die betreffenden Geräteeinschübe mit ihren Frontplatten die gesamte Schrankvorderseite abschließen und außerdem durch natürliche Konvektion mit einem zur Oberseite führenden Luftabzugskamin verbunden sind. Die zu kühlenden Einschübe weisen ferner horizontale Chassisböden mit daran angebrachten, ebenfalls horizontalen Rippenkühlkörpern auf, deren Kühlkanäle von der Schrankvorderseite zur Schrankrückseite verlaufen und in den auf der Schrankrückseite ausgebildeten Abzugskamin münden. An den Frontplatten dieser zu kühlenden Einschübe sind zu den Kühlkanälen dieser Rippenkühlkörper führende Lufteinlaßöffnungen vorgesehen. Von Nachteil bei dieser bekannten Einrichtung ist jedoch ebenfalls der Umstand, daß für die Kühlung der in unterschiedlichen Höhen des Schrankgestells angeordneten Geräteeinschübe unterschiedlich warme Kühlluft zur Verfügung steht, womit die Kühlwirkung in den verschiedenen Höhen ebenfalls unterschiedlich sein wird.

Es ist schließlich auch schon ein durch natürliche Luftkonvektion geführtes elektronisches Gestell mit wenigstens zwei Kästen bekannt (EP-B1-20 084), welche so übereinander angeordnet sind, daß sie zwischeneinander einen Zwischenraum begrenzen. Dabei ist wenigstens eine in den Zwischenraum sich öffnende Luftströmungsöffnung in der Oberseite des unteren Kastens vorgesehen, und ferner ist wenigstens eine in den Zwischenraum sich öffnende Luftströmungsöffnung in der Unterseite des oberen Kastens vorgesehen. Schließlich ist wenigstens eine Einrichtung zur Kanalisierung der Luft von der jeweiligen Öffnung in dem unteren Kasten zu wenigstens einer Auslaßöffnung sowie zur Kanalisierung von Luft von wenigstens einer Einlaßöffnung zu der jeweiligen Öffnung in dem oberen Kasten hin vorgesehen. Die Einlaßöffnungen und die Auslaßöffnungen sind dabei in verschiedenen Bereichen der Vorderseite des Zwischenraums angeordnet. Die Luftkanalisierungseinrichtung umfaßt eine Trenneinrichtung, welche den Zwischenraum in obere und untere Abteile unterteilt, die mit den Öffnungen des jeweiligen oberen bzw. unteren Kastens in Strömungsverbindung stehen. Eines der erwähnten Abteile ist dabei so angeordnet, daß es direkt mit der Vorderseite des Zwischenraums in Strömungsverbindung steht. Von einer Öffnung erstreckt sich dabei ein Durchgang durch das genannte eine Abteil in die Trenneinrichtung hinein, um das andere Abteil mit der Vorderseite des Zwischenraums zu verbinden. Die Trenneinrichtung und der betreffende Durchgang sind dabei so angeordnet, daß das obere Abteil nur mit einer oder mehreren Zuleitungsöffnungen in einem unteren Bereich an der Vorderseite des Zwischenraums in Strömungsverbindung steht und daß das untere Abteil nur mit einer oder mehreren Auslaßöffnungen oberhalb der jeweiligen Einlaßöffnung in einem oberen Bereich an der erwähnten Vorderseite des genannten Zwischenraums in Strömungsverbindung steht. Damit haftet aber auch diesem bekannten elektronischen Gestell der gleiche Mangel an, der im Zusammenhang mit der eingangs betrachteten bekannten Vorrichtung aufgezeigt worden ist.

Der Erfindung liegt demgemäß die Aufgabe zugrunde, einen Weg zu zeigen, wie eine Vorrichtung der eingangs genannten Art auszubilden ist, um bei relativ geringem konstruktivem Aufwand sicherzustellen, daß den in unterschiedlichen Höhen des Gestells übereinander angeordneten Einschüben bzw. den in diesen enthaltenen elektrischen bzw. elektronischen Baugruppen bzw. Bauelementen Kühlluft mit praktisch der gleichen Lufttemperatur zugeführt werden kann, so daß für sämtliche zu kühlenden elektronischen Baugruppen bzw. Bauelemente die gleiche Kühlwirkung erzielt werden kann.

Gelöst wird die vorstehend aufgezeigte Aufgabe bei einer Vorrichtung der eingangs genannten Art erfindungsgemäß dadurch, daß an der Gestellunterseite und auf wenigstens einer Gestellseite und/oder auf der Gestellrückseite eine Kanalanordnung vorgesehen ist, die mit einer an der Gestellunterseite vorgesehenen Kühlluft-Zufuhreinrichtung verbunden ist und die mit den offenen Unterseiten sämtlicher Einschübe für die Aufnahme von Kühlluft in Verbindung steht.

Die Erfindung bringt den Vorteil mit sich, daß mit einem insgesamt relativ geringen konstruktiven Aufwand erreicht ist, daß sämtlichen in dem Gestell übereinander angeordneten Einschüben damit den in diesen Einschüben untergebrachten elektrischen Baugruppen bzw. Bauelementen Kühlluft praktisch mit ein und derselben Temperatur zugeführt werden kann. Dabei wird Kühlluft von der untersten Stelle des betreffenden Gestells verwendet, also von der Stelle, an der die Luft normalerweise die niedrigste Temperatur innerhalb des Raumes hat, in dem sich das betreffende Gestell befindet.

Zweckmäßigerweise dient die genannte Kanalanordnung zugleich für die Aufnahme von zu/von den Einschüben hinführenden/wegführenden Kabeln. Dies bringt den Vorteil mit sich, daß die betreffende Kanalanordnung nicht gesondert vorgesehen zu werden braucht, sondern daß hierfür bereits vorhandene Kabelkanäle ausgenutzt werden können.

Zweckmäßigerweise enthält die erwähnte Kanalanordnung lediglich einen einzigen Kanal. Dies bringt den Vorteil eines besonders geringen konstruktiven Aufwands mit sich.

Die Kanalanordnung besteht zweckmäßigerweise aus von der Kühlluft-Zufuhreinrichtung zu den Unterseiten der einzelnen Einschübe individuell hinführenden Kanälen. Dies bringt den Vorteil mit sich, für die einzelnen Einschübe den jeweiligen Bedürfnissen entsprechende Kühlluft bereitstellen zu können.

Vorzugsweise weisen jedoch sämtliche zuvor erwähnten Kanäle gleiche Querschnittsflächen auf. Dies bringt den Vorteil eines besonders geringen konstruktiven Aufwands mit sich.

Es ist aber auch möglich, daß die einzelnen Kanäle dem Kühlluftbedarf in den mit ihnen verbundenen Einschüben entsprechende Querschnittsflächen aufweisen. Von dieser Maßnahme wird in vorteilhafter Weise dann Gebrauch gemacht, wenn die einzelnen Einschübe unterschiedliche Wärmemengen abzuführen haben.

Jeder Einschub weist vorzugsweise zwei luftundurchlässige Seitenplatten auf, die durch eine luftundurchlässige Deckplatte und durch eine luftundurchlässige Rückplatte miteinander verbunden sind. Durch diese Maßnahme ist in vorteilhafter Weise sichergestellt, daß Kühlluft in den jeweiligen Einschub nur von dessen Unterseite her eintreten kann.

Zweckmäßigerweise weist jeder Einschub auf seiner Oberseite eine schräg nach oben verlaufende luftundurchlässige Deckplatte auf. Dadurch ergibt sich der Vorteil, daß die in dem jeweiligen Einschub nach oben steigende Warmluft aus dem betreffenden Einschub auf relativ einfache Weise durch Umlenkung an der betreffenden Deckplatte abgeführt werden kann.

Vorzugsweise besteht zumindest die Deckplatte des jeweiligen Einschubs aus Kunststoff. Hierdurch ergibt sich der Vorteil, daß auf besonders einfache Weise sichergestellt werden kann, daß die aus einem Einschub austretende Warmluft nicht zu einer unerwünschten Erwärmung der in den darüberliegenden Einschub eintretenden Kühlluft beitragen kann. Erreicht wird dies durch die Ausnutzung der schlechten Wärmeleitfähigkeit von Kunststoffen.

Sofern erforderlich, kann in der Kühlluft-Zufuhreinrichtung zumindest ein Gebläse enthalten sein. Von dieser Maßnahme wird in vorteilhafter Weise dann Gebrauch gemacht, wenn von den einzelnen zu kühlenden Baugruppen bzw. Bauelementen relativ viel Wärme abzuführen ist.

Anhand von Zeichnungen wird die Erfindung nachstehend beispielsweise näher erläutert.

FIG 1 zeigt in einer schematischen Vorderansicht ein Gestell, bei dem die Vorrichtung gemäß der Erfindung angewandt ist.

FIG 2 zeigt eine Seitenansicht längs der in FIG 1 eingetragenen Schnittlinie II-II.

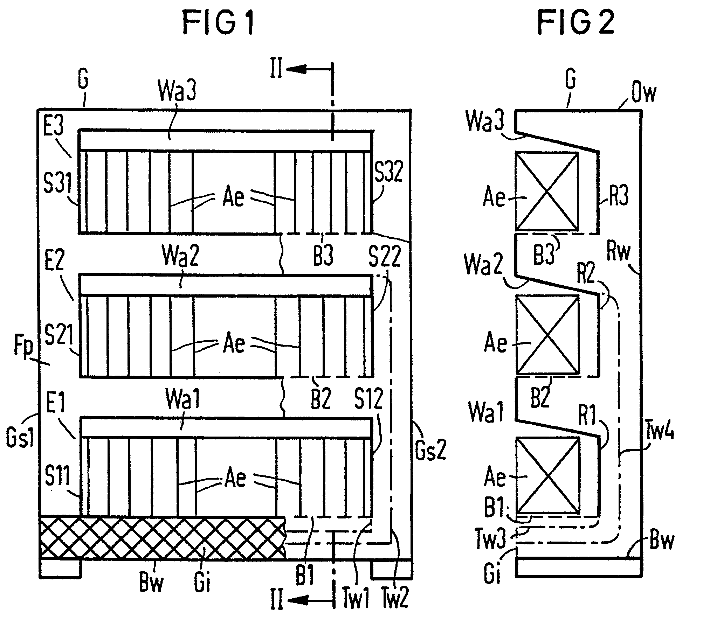

In FIG 1 ist schematisch ein Gestell G angedeutet, welches zur Aufnahme von drei übereinander angeordneten Einschüben E1, E2, E3 dient, die im vorliegenden Fall fester Bestandteil des Gestells G sein mögen. Jeder der genannten Einschübe besteht aus zwei luftundurchlässigen Seitenwänden, einer luftdurchlässigen Bodenwand, einer luftundurchlässigen Rückwand und einer schräg nach oben und vorn verlaufenden luftundurchlässigen Deckplatte. Die Seitenplatten, die Deckplatte und die Rückplatte des jeweiligen Einschubs sind miteinander verbunden, und zwar luftundurchlässig. Zu dem Einschub E1 gehören dabei die Seitenplatten S11 und S12 sowie die Deckplatte Wa1 und die Rückplatte R1 (Aus FIG 2 ersichtlich). Zu dem Einschub E2 gehören in entsprechender Weise die Seitenplatten S21, S22 sowie die Deckplatte Wa2 und die Rückplatte R2. Zu dem Einschub E3 gehören schließlich die Seitenplatten S31 und S32 sowie die Deckplatte Wa3 und die Rückplatte R3.

Auf der Unterseite ist der jeweilige Einschub E1, E2, E3 luftdurchlässig ausgebildet. Gemäß Figuren 1 und 2 sind die Unterseiten der betreffenden Einschübe E1, E2, E3 durch die luftdurchlässigen Bodenplatten B1, B2 bzw. B3 gebildet. Diese Bodenplatten sind so ausgebildet, daß sie im vorliegenden Fall als Baugruppenträger für einzelne Baugruppen oder gedruckte Schaltungen enthaltende Schaltungsplatinen geeignet sind, die elektrische Baugruppen bzw. Bauelemente tragen. Diese generell als Aufnahmeeinrichtungen Ae bezeichneten Baugruppen- bzw. Bauelementeaufnahmen sind jene Einrichtungen, welche zu kühlende Baugruppen bzw. Bauelemente tragen.

Das in Figuren 1 und 2 angedeutete Gestell G weist in Abstand von den Rückwänden der einzelnen Einschübe eine geschlossene Rückwand Rw, ferner eine obere geschlossene Wand Ow, eine im vorliegenden Fall ebenfalls geschlossene Bodenwand Bw sowie in Abstand von den Seitenplatten der Einschübe vorgesehene geschlossene Gestellseitenwände Gs1, Gs2 auf. Die Vorderseite des Gestells ist durch eine Frontplatte Fp abgeschlossen, die im vorliegenden Fall Ausschnitte für die Aufnahme der Einschübe E1, E2 und E3 aufweist. Diese Frontplatte Fp ist im übrigen mit den Seitenwänden Gs1, Gs2 sowie mit der oberen Wand Ow und der Bodenwand Bw des betreffenden Gestells G fest verbunden, d.h. luftundurchlässig verbunden.

Im unteren Bereich weist das in Figuren 1 und 2 dargestellte Gestell eine für die Aufnahme von Kühlluft dienende Kühlluft-Zufuhreinrichtung auf, die durch ein Gitter Gi zur Vorderseite des Gestells G hin abgedeckt sein kann. In die betreffende Kühlluft-Zufuhreinrichtung eintretende Kühlluft vermag durch Konvektion sowohl durch die luftdurchlässige Bodenwand B1 des Einschubs E1 als auch durch die luftdurchlässigen Bodenwände B2, B3 der anderen beiden Einschübe E2, E3 einzutreten. Dazu strömt die betreffende Kühlluft durch eine Kanalanordnung, die sich an der Gestellunterseite und auf wenigstens einer Gestellseite und/oder auf der Gestellrückseite befinden kann und die mit der Kühlluft-Zufuhreinrichtung in Strömungsverbindung steht. An dieser Stelle sei angemerkt, daß gegebenenfalls in der Kühlluft-Zufuhreinrichtung wenigstens ein Gebläse enthalten sein kann, welches die Kühlluft zu den betreffenden Einschüben hin bläst.

Die an den einzelnen Baugruppen- bzw. Bauelemente-Aufnahmeeinrichtungen Ae entlangströmende Kühlluft führt die Wärme von den einzelnen warmen Baugruppen bzw. Bauelementen ab und strömt innerhalb des jeweiligen Einschubs nach oben, um an der jeweiligen Deckplatte Wa1, Wa2 bzw. Wa3 zur Gestellvorderseite hin umgeleitet zu werden. Dadurch strömt dann warme Abluft an der Vorderseite des Gestells G nach oben. Demgemäß ist den in den verschiedenen Einschüben E1, E2 und E3 enthaltenen elektrischen Baugruppen bzw. Bauelementen stets Kühlluft zugeführt, die für sämtliche Einschübe praktisch die gleiche Temperatur hat. Besonders einfach läßt sich diese gleiche Temperatur für die betreffende Kühlluft dann erreichen, wenn zumindest die Deckplatten Wa1, Wa2, Wa3 der einzelnen Einschübe E1, E2 bzw. E3 aus einem Kunststoff bestehen, der eine geringe Wärmeleitfähigkeit aufweist. Es ist aber auch ohne weiteres denkbar, daß andere Plattenteile des jeweiligen Einschubs aus Kunststoff bestehen, um die Erwärmung der erwähnten Kühlluft zu verhindern, die in den jeweils nächst höheren Eischub eintritt.

Zuvor ist erläutert worden, daß die durch das Gitter Gi der Kühlluft-Abgabeeinrichtung eintretende Kühlluft zu der luftdurchlässigen Bodenwand B1, B2, B3 des jeweiligen Einschubs E1, E2 bzw. E3 hinströmt. Bezüglich der Bodenwand B1 des Einschubs E1 ist dabei eine direkte Strömungsverbindung von der Vorderseite des Gestells G her vorhanden. Bezüglich der anderen beiden Einschübe E2 und E3 ist eine Strömungsverbindung über eine Kanalanordnung vorhanden, die auf wenigstens einer Gestellseite und/oder auf der Gestellrückseite des Gestells G vorhanden ist. Diese Kanalanordnung, die für die Aufnahme von zu/von den einzelnen Einschüben hinführenden/wegführenden Kabeln dienen kann, braucht prinzipiell entweder nur auf einer Gestellseite und/oder der Gestellrückseite vorgesehen zu sein. Dabei kann die betreffende Kanalanordnung lediglich einen einzigen Kanal enthalten, der entweder auf einer einzigen Gestellseite verläuft oder der auf beiden Gestellseiten und/oder auf der Gestellrückseite verläuft. In diesem Zusammenhang ist jedoch anzumerken, daß es ohne weiteres möglich ist, die erwähnte Kanalanordnung aus mehreren einzelnen Kanälen zu bilden, die durch Trennwände voneinander getrennt sind. Derartige Trennwände sind in FIG 1 mit Tw1 und Tw2 bezeichnet, und in FIG 2 sind derartige Trennwände mit Tw3 und Tw4 bezeichnet. Diese Trennwände sind luftundurchlässig; sie können jeweils so angeordnet sein, daß mit den durch sie geschaffenen Luftkanälen dem Kühlbedürfnis in den unterschiedlichen Einschüben entsprechend Rechnung getragen ist. Wenn man davon ausgeht, daß sämtliche Einschübe bzw. die darin enthaltenen zu kühlenden Einrichtungen den gleichen Kühlluftbedarf haben, dann werden die zuvor erwähnten Kanäle gleiche Querschnittsflächen aufweisen.

Bei der vorstehend erläuterten Vorrichtung gemäß Figuren 1 und 2 ist angenommen worden, daß die Kühlluft durch das Gitter Gi den einzelnen Einschüben zugeführt wird. Es dürfte jedoch ohne weiteres einzusehen sein, daß eine entsprechende oder gegebenenfalls zusätzliche Kühlluftzufuhr auch von einer luftdurchlässigen Bodenwand Bw und/oder von in Höhe des Gitters Gi entsprechenden vorhandenen Bereichen der Gestellseitenwände Gs1, Gs2 und/oder der Rückwand Rw möglich ist.

Abschließend sei noch angemerkt, daß bei der vorstehend beschriebenen Ausführungsform der Erfindung die Rückwand des Gestells als gschlossene Wand ausgebildet ist. Es ist jedoch auch möglich, ohne solche Rückwand auszukommen, wenn man zwei Gestelle der erläuterten Art Rücken an Rücken zusammenstellt bzw. in dieser Weise von vornherein aufbaut.

## Patentansprüche

1. Vorrichtung zum Kühlen von elektronischen Baugruppen bzw. Bauelementen (Ae), die in in einem Gestell (G) übereinander angeordneten Einschüben (E1, E2, E3) untergebracht sind, mit Hilfe von den einzelnen Einschüben (E1, E2, E3) von deren jeweiliger Unterseite her zugeführter Kühlluft, die nach Erwärmung in dem jeweiligen Einschub (E1, E2, E3) aus diesem als Warmluft austritt, dadurch gekennzeichnet, daß an der Gestellunterseite und wenigstens einer Gestellseite und/oder auf der Gestellrückseite eine Kanalanordnung vorgesehen ist, die mit einer an der Gestellunterseite vorgesehenen Kühlluft-Zufuhreinrichtung (Gi) verbunden ist und die mit den offenen Unterseiten (B1, B2, B3) sämtlicher Einschübe (E1, E2, E3) für die Aufnahme von Kühlluft in Verbindung steht.

2. Vorrichtung nach Anspruch 1, dadurch gekennzeichnet, daß die Kanalanordnung zugleich für die Aufnahme von zu/von den Einschüben hinführenden/wegführenden Kabeln dient.

3. Vorrichtung nach Anspruch 1 oder 2, dadurch gekennzeichnet, daß die Kanalanordnung lediglich einen einzigen Kanal enthält.

4. Vorrichtung nach Anspruch 1 oder 2, dadurch gekennzeichnet, daß die Kanalanordnung aus von der Kühlluft-Zufuhreinrichtung (Gi) zu den Unterseiten der einzelnen Einschübe (E1, E2, E3) individuell hinführenden Kanälen besteht.

5. Vorrichtung nach Anspruch 4, dadurch gekennzeichnet, daß sämtliche Kanäle gleiche Querschnittsflächen aufweisen.

6. Vorrichtung nach Anspruch 4, dadurch gekennzeichnet, daß die einzelnen Kanäle dem Kühlluftbedarf in den mit ihnen verbundenen Einschüben (E1, E2, E3) entsprechende Querschnittsflächen aufweisen.

7. Vorrichtung nach einem der Ansprüche 1 bis 6, dadurch gekennzeichnet, daß jeder Einschub (E1, E2, E3) zwei luftundurchlässige Seitenplatten (S11, S12; S21, S22; S31, S32) aufweist, die durch eine luftundurchlässige Deckplatte (Wa1; Wa2; Wa3) und durch eine luftundurchlässige Rückplatte (R1; R2; R3) miteinander verbunden sind.

8. Vorrichtung nach einem der Ansprüche 1 bis 7, dadurch gekennzeichnet, daß jeder Einschub (E1, E2, E3) auf seiner Oberseite eine schräg nach oben verlaufende luftundurchlässige Deckplatte (Wa1, Wa2, Wa3) aufweist.

9. Vorrichtung nach einem der Ansprüche 1 bis 8, dadurch gekennzeichnet, daß zumindest die Deckplatte (Wa1; Wa2; Wa3) des jeweiligen Einschubs (E1, E2, E3) aus Kunststoff besteht.

10. Vorrichtung nach einem der Ansprüche 1 bis 9, dadurch gekennzeichnet, daß in der Kühlluft-Zufuhreinrichtung (Gi) wenigstens ein Gebläse enthalten ist.

## Claims

1. Cooling device for electronic assemblies or components (Ae) which are accommodated in slide-in units (E1, E2, E3) arranged one above the other in a rack (G), with the aid of cooling air which is supplied to the individual slide-in (E1, E2, E3) from their respective undersides and which, after heating up in the respective slide-in unit (E1, E2, E3), comes out of the latter as warm air, characterized in that a channel arrangement is provided on the rack underside and at least on one rack side and/or on the rack rear side, which channel arrangement is connected to a cooling air supply facility provided on the rack underside and which is connected to the open undersides (B1, B2, B3) of all slide-in units (E1, E2, E3) for receiving cooling air.

2. Device according to Claim 1, characterized in that the channel arrangement simultaneously serves to receive the cables leading to/leading away from the slide-in units.

3. Device according to Claim 1 or 2, characterized in that the channel arrangement contains only one single channel.

4. Device according to Claim 1 or 2, characterized in that the channel arrangement consists of channels leading individually from the cooling air supply facility (Gi) to the undersides of the individual slide-in units (E1, E2, E3).

5. Device according to Claim 4, characterized in that all channels have the same cross-sectional areas.

6. Device according to Claim 4, characterized in that the individual channels have cross-sectional areas corresponding to the cooling air requirement in the slide-in units (E1, E2, E3) connected thereto.

7. Device according to one of Claims 1 to 6, characterized in that each slide-in unit (E1, E2, E3) has two side panels (S11, S12; S21, S22; S31, S32) impermeable to air, which are interconnected by a top panel (Wa1; Wa2; Wa3) impermeable to air and by a rear panel (R1; R2; R3) impermeable to air.

8. Device according to one of Claims 1 to 7, characterized in that each slide-in unit (E1, E2, E3) has on its top side a top panel (Wa1, Wa2, Wa3) which extends obliquely upwards and is impermeable to air.

9. Device according to one of Claims 1 to 8, characterized in that at least the top panel (Wa1; Wa2; Wa3) of the respective slide-in unit (E1, E2, E3) is made of plastic.

10. Device according to one of Claims 1 to 9, characterized in that at least one fan is contained in the cooling air supply facility (Gi).

## Revendications

1. Dispositif pour le refroidissement de sous-ensemble ou composants électroniques (Ae) logés dans des tiroirs ou modules (E1, E2, E3) superposés dans une baie (G), à l'aide d'air de refroidissement amené aux différents tiroirs (E1, E2, E3) par leur dessous et quittant chaque tiroir (E1, E2, E3), après y avoir été chauffé, sous forme d'air chaud, caractérisé en ce qu'un système de canalisation est prévu sur le dessous de la baie et au moins l'un des côtés latéraux de la baie et/ou sur son côté arrière, système de canalisation qui est relié à un dispositif d'amenée d'air froid prévu sur le côté inférieur de la baie et qui communique avec les côtés inférieurs ouverts (B1, B2, B3) de tous les tiroirs (E1, E2, E3) pour la réception d'air de refroidissement.

2. Dispositif selon la revendication 1, caractérisé en ce que le système de canalisation sert en même temps à la réception de câbles menant aux tiroirs ou venant de ceux-ci.

3. Dispositif selon la revendication 1 ou 2, caractérisé en ce que le système de canalisation ne comporte qu'un seul canal.

4. Dispositif selon la revendication 1 ou 2, caractérisé en ce que le système de canalisation est constitué de canaux partant du dispositif d'amenée d'air de refroidissement (Gi) et menant individuellement aux côtés inférieurs des différents tiroirs (E1, E2, E3).

5. Dispositif selon la revendication 4, caractérisé en ce que tous les canaux possèdent des aires de section droite égales.

6. Dispositif selon la revendication 4, caractérisé en ce que les différents canaux présentent des aires de section droite qui correspondent aux besoins en air de refroidissement dans les tiroirs (E1, E2, E3) reliés à eux.

7. Dispositif selon une des revendications 1 à 6, caractérisé en ce que chaque tiroir (E1, E2, E3) possède deux plaques latérales (S11, S12; S21, S22; S31, S32) imperméables à l'air, qui sont reliées entre elles par une plaque de recouvrement (Wa1; Wa2; Wa3) imperméable à l'air et par une plaque arrière (R1; R2; R3) imperméable à l'air.

8. Dispositif selon une des revendications 1 à 7, caractérisé en ce que chaque tiroir (E1, E2, E3) possède sur son côté supérieur une plaque de recouvrement (Wa1; Wa2; Wa3) imperméable à l'air, qui s'étend obliquement vers le haut.

9. Dispositif selon une des revendications 1 à 8, caractérisé en ce qu'au moins la plaque de recouvrement (Wa1; Wa2; Wa3) de chaque tiroir (E1, E2, E3) est en matière plastique.

10. Dispositif selon une des revendications 1 à 9 caractérisé en ce que le dispositif d'amenée d'air de refroidissement (Gi) contient au moins un ventilateur.

# FIG 1

# FIG 2